# EUROPEAN PATENT APPLICATION

(11) **EP 4 443 482 A1**
(43) Date of publication of application: **09.10.2024**
(21) Application number: 21966041.2
(22) Date of filing: 02.12.2021
(51) Int. Cl.: H01L 21/673, C23C 16/458

(54) **HIGH-TEMPERATURE TUBE FURNACE**

(71) Applicant: ACM Research (Shanghai) Inc., Shanghai 201203 (CN); ACM Research (Lingang), Inc., Shanghai 201303 (CN); ACM Research Korea Co., Ltd., Icheon-si, Gyeonggi-do (KR); Cleanchip Technologies Limited, Hong Kong (HK)
(72) Inventor: WANG, Hui, Shanghai 201203 (CN); ZHANG, Shan, Shanghai 201203 (CN); SHEN, Hui, Shanghai 201203 (CN); LV, Ce, Shanghai 201203 (CN); ZHOU, Dongcheng, Shanghai 201203 (CN); KIM, John, ICHEON-SI, GYEONGGI-DO (KR); PARK, Jae Sung, ICHEON-SI, GYEONGGI-DO (KR); WANG, Jian, Shanghai 201203 (CN); WANG, Jun, Shanghai 201203 (CN); JIA, Shena, Shanghai 201203 (CN); ZHANG, Xiaoyan, Shanghai 201203 (CN); KIM, Yy, ICHEON-SI, GYEONGGI-DO (KR)
(74) Representative: Osha BWB
(86) International application number: PCT/CN2021/135082
(87) International publication number: WO 2023/097609

(57) **Abstract**

A high-temperature tube furnace comprises: a process tube (1) with a top cover (101) arranged on the top end thereof, the top cover (101) being provided with through holes (1011); a gas supply pipe (2) communicating with the through holes (1011) of the top cover (101) of the process tube (1), process gas being introduced into the process tube (1) through the gas supply pipe (2) and the through holes (1011) of the top cover (101) of the process tube (1); a wafer boat (3) arranged in the process tube (1), and comprising a supporting frame (301) and supporting plates (302), the supporting plates (302) being distributed in multiple layers along the length direction of the supporting frame (301) and used for supporting multiple substrates (w), each substrate (w) being placed on one supporting plate and each supporting plate supporting the entire bottom of the substrate (w). The multiple layers of supporting plates (302) are provided, and each supporting plate (302) supports the entire bottom of a substrate (w), thus avoiding defects of lattices in the substrates (w) caused by downward deformation of the substrates (w) during a high temperature process of 1200°C or above, and improving the yield of chips.

## Description

### BACKGROUND OF THE INVENTION

### Field of the Invention

The present invention relates to the field of semiconductor manufacturing devices, and in particular, to a high-temperature tube furnace.

### The Related Art

A high-temperature tube furnace is mostly applied to semiconductor processes such as vapor deposition, oxidizing annealing and so on. At present, the temperature of traditional semiconductor vapor deposition process is 800 °C to 1100 °C. However, with the development of semiconductor power devices and more advanced semiconductor process devices, the process temperature requirements for high-temperature tube furnace are getting higher and higher. The traditional process temperature of 800 °C to 1100 °C no longer meet the demand.

During the semiconductor process, in order to increase the diffusion rate of doped atoms in the silicon wafer, and to increase the deposition rate of the oxide film, thereby increasing the output of the equipment, the process temperature needs to reach over 1200 °C and the process temperature is usually less than 1300 °C.

Special-shaped process tubes made of quartz or silicon carbide are usually applied in high-temperature tube furnace, where the melting temperature of quartz is around 1700 °C. When the high-temperature tube furnace is used for a long time under the high-temperature process condition above 1200 °C, the top of the process tube is affected by its own gravity and pressure. It tends to cause the central part of the process tube to collapse downwards, thus resulting in the deformation of the process tube, which cannot meet subsequent production needs.

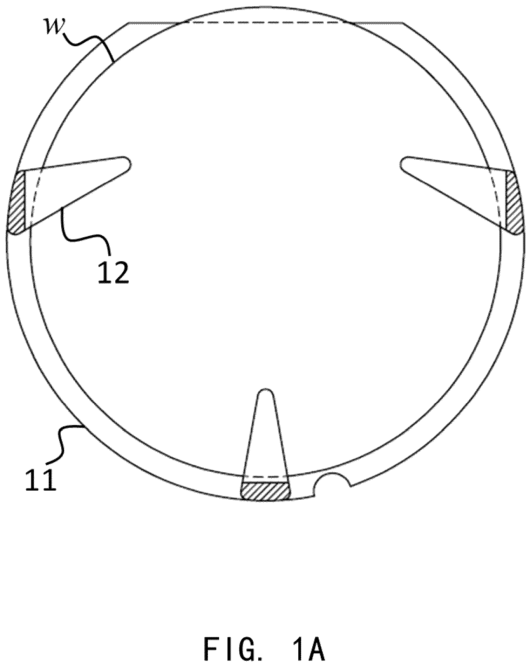

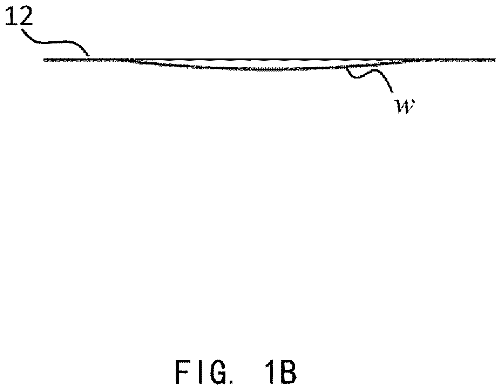

At the same time, the material of a substrate is mostly silicon, and the melting temperature of a silicon substrate is about 1410 °C. Similarly, as shown in FIG. 1A, a supporting frame 11 and supporting fins 12 connected to it are provided on the wafer boat in the existing high-temperature tube furnace. There are three supporting fins 12 determining one supporting surface in order to support each silicon substrate w. However, as shown in FIG. 1B, the three supporting fins 12 can only support the periphery of each silicon substrate w. When the high-temperature tube furnace is used under a high-temperature process condition above 1200 °C, it is easy to cause the center of the silicon substrate w to collapse downward, thereby aggravating the deformation of the central area of the silicon substrate w, and then increasing the density of lattice dislocation defects within the substrate, resulting in a decrease in the yield of the chip.

Therefore, the traditional high-temperature tube furnace is prone to cause deformation and damage of process tube, wafer boat and silicon substrate under high-temperature process conditions, which leads to a decrease in the service life of a high-temperature tube furnace, thereby increasing the use cost.

In summary, it is necessary to propose a new tube furnace structure to solve the above problem.

### SUMMARY

In view of the disadvantages of the above-described prior art, the present invention aims to provide a high-temperature tube furnace, solving the problem that the process tube, wafer boat and substrate of the high-temperature tube furnace in the prior art are prone to deformation.

To achieve the above objective and other related ones, the present invention proposes a high-temperature tube furnace comprising:
a process tube, with a top cover arranged on the top end, the top cover having a plurality of through holes;
a gas supply pipe, connecting to the through holes of the top cover of the process tube for introducing the process gas into the process tube through the gas supply pipe and the through holes of the top cover of the process tube;
a wafer boat, arranged in the process tube and comprising a supporting frame and supporting plates, wherein the supporting plates are distributed in a plurality of layers along the length direction of the supporting frame to support multiple substrates, and each substrate is placed on each layer of the supporting plate for holding the entire bottom of each substrate.

In one embodiment of the present invention, three guide grooves are provided on each layer of supporting plate, three suckers are provided on a manipulator for taking and placing the substrate, three guide grooves correspond to three suckers on the manipulator, three suckers are inserted into three guide grooves to take the substrate from the supporting plate or place the substrate on the supporting plate.

In one embodiment of the present invention, two guide grooves are provided on each layer of supporting plate, three suckers are provided on a manipulator for taking and placing the substrate, two suckers correspond to one guide groove, the remaining one sucker corresponds to the other guide groove, three suckers are inserted into two guide grooves to take the substrate from the supporting plate or place the substrate on the supporting plate.

In one embodiment of the present invention, the three suckers on the manipulator are vacuum suckers for sucking the substrate.

In one embodiment of the present invention, the three suckers on the manipulator are all solid suckers and each of them is provided with a sealing ring, the solid suckers support the substrate through the friction of the sealing ring.

In one embodiment of the present invention, at least two slots are provided at the periphery of each layer of supporting plate, the supporting frame is provided with at least two blocks at the position corresponding to each layer of supporting plate, at least two blocks correspond to at least two slots one-to-one, and each layer of supporting plate is stuck to the blocks of the supporting frame through the slots.

In one embodiment of the present invention, the number of slots is four, the number of the blocks is four, and the four blocks are symmetrically arranged on both sides of the circumferential direction of each layer of supporting plate.

In one embodiment of the present invention, the number of slots is three, three slots are uniformly distributed on the periphery of each supporting plate, and the angle between the two adjacent slots is 120°, the number of blocks is three, which correspond to the three slots one-to-one.

In one embodiment of the present invention, the supporting plate and the supporting frame are made of different materials.

In one embodiment of the present invention, the supporting plate and the supporting frame are made of same material and formed in one.

In one embodiment of the present invention, the material of the supporting plate is any one of quartz, silicon carbide, diamond, graphite, and graphene.

In one embodiment of the present invention, the material of the supporting frame is any one of quartz, silicon carbide, and silicon.

In one embodiment of the present invention, a plurality of protrusions or grooves are provided on the side of the supporting plate in contact with the bottom of the substrate.

In one embodiment of the present invention, the top cover of the process tube is a double-layer structure including a top layer and a bottom layer, both layers of the top cover are arched structures.

In one embodiment of the present invention, stiffeners are provided between the top layer and the bottom layer of the top cover to connect the top layer and the bottom layer of the top cover.

In one embodiment of the present invention, the top cover is a double-layer structure including a top layer and a bottom layer, the top layer of the top cover is an arched structure, and the bottom layer of the top cover is a planar structure, stiffeners are arranged between the top layer and the bottom layer of the top cover to connect the top layer and the bottom layer of the top cover.

In one embodiment of the present invention, the material of the process tube is quartz or silicon carbide.

In one embodiment of the present invention, the high-temperature tube furnace further comprises:
a liner tube, sleeved the periphery of the process pipe; and
heating element, sleeved the periphery of the liner tube.

In one embodiment of the present invention, the material of the liner tube is quartz or silicon carbide.

As mentioned above, compared with the prior art, the high-temperature tube furnace proposed in the present invention has the following beneficial effects:
1. In the high-temperature tube furnace provided by the present invention, multiple layers of supporting plate are provided, and each layer of supporting plate supports the entire bottom of a substrate, avoiding defects of lattices in the substrates caused by downward deformation of the substrates during a high temperature process of 1200°C or above, and improving the yield of chips.
2. In the high-temperature tube furnace provided by the present invention, the top cover of the process tube is arranged into a double-layer arch structure, so that the bottom layer of the top cover of the process tube is not easy to collapse during the high temperature process of 1200°C or above, the stress and deformation in the top cover of the process tube are prevented, the service life of the high-temperature tube furnace is prolonged, and the use cost is reduced.

### BRIEF DESCRIPTION OF THE DRAWINGS

FIG. 1A illustrates a schematic diagram of a supporting fin and supporting substrate of a wafer boat in the prior art.
FIG. 1B illustrates a diagram of a supporting fin and supporting substrate in the prior art in which the substrate collapses at high temperature.
FIG. 2 shows a schematic diagram of a high-temperature tube furnace provided by a first embodiment of the present invention.
FIG. 3 illustrates a schematic diagram of a wafer boat provided by a first embodiment of the present invention.
FIG. 4A shows a top view of a supporting plate in the AA direction in FIG. 3 provided by a first embodiment of the present invention.
FIG. 4B illustrates a schematic diagram of a manipulator coordinating to a supporting plate provided by a first embodiment of the present invention.
FIG. 4C illustrates a schematic diagram of a manipulator inserting the sucker into the guide groove of the supporting plate provided by a first embodiment of the present invention.
FIGS. 5A, 5B and FIG. 5C respectively illustrate a bottom view, a top view and a front view of the sucker inserted into the guide groove on the manipulator provided in a first embodiment of the present invention.
FIG. 6A shows a schematic diagram of a supporting plate coordinating to a manipulator provided by a second embodiment of the present invention.
FIG. 6B, FIG. 6C and FIG. 6D respectively illustrate a bottom view, a top view and a front view of the vacuum sucker inserted into the guide groove to remove a substrate on the manipulator provided in a second embodiment of the present invention.
FIG. 7 shows a schematic diagram of the three slots on the supporting plate coordinating to the three blocks on the supporting frame provided by a third embodiment of the present invention.
FIG. 8A, FIG. 8B and FIG. 8C respectively illustrate sectional views in the BB' direction shown in FIG. 4A of different types of supporting plates provided by a first embodiment and other embodiments of the present invention.
FIG. 9A and FIG. 9B respectively show a partial sectional view and a cross-sectional view of the top cover of the process tube provided by a first embodiment of the present invention.
FIG. 10A and FIG. 10B respectively show a partial sectional view and a cross-sectional view of the top cover of the process tube provided by a fourth embodiment of the present invention.
FIG. 11A and FIG. 11B respectively illustrate a partial sectional view and a cross-sectional view of the top cover of the process tube provided by a fifth embodiment of the present invention.

### DETAILED DESCRIPTION OF EMBODIMENTS

Embodiments of the present invention are described through particular specific examples below, and other advantages and benefits of the present invention can be easily understood by those skilled in the art from the content disclosed in the specification. The present invention may also be implemented or applied in various other specific embodiments, and the details in the specification may also be modified or altered in various ways based on different viewpoints and applications without departing from the spirit of the present invention.

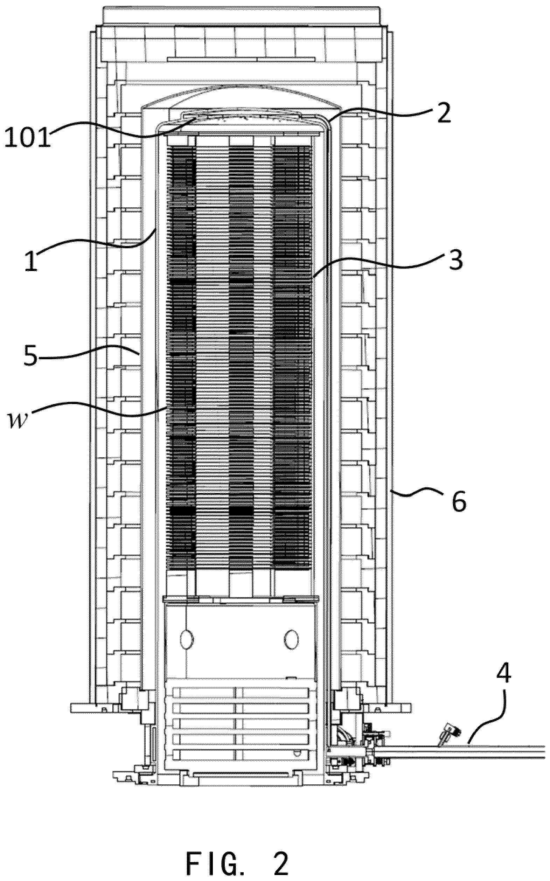

Please refer to FIG. 2 to FIG. 11B. It should be noted that the diagrams provided in this embodiment illustrate the basic concept of the present invention only in a schematic manner. Although only the components related to the present invention are shown in the diagrams instead of being drawn according to the number, shape and size of components in actual implementation, the shape, number and proportion of each component in actual implementation can be changed at will, and the layout of the components can also be more complicated.

### First embodiment

As shown in FIG. 2, the present invention provides a high-temperature tube furnace. Specifically, the high-temperature tube furnace comprises a process tube 1, a gas supply pipe 2, a wafer boat 3, an external gas tube 4, a liner tube 5 and a heating element 6.

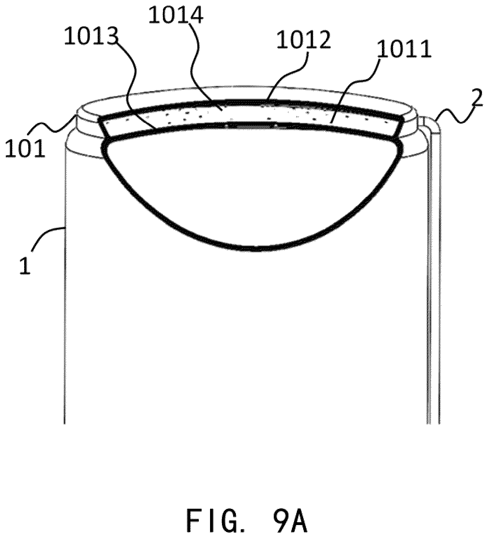

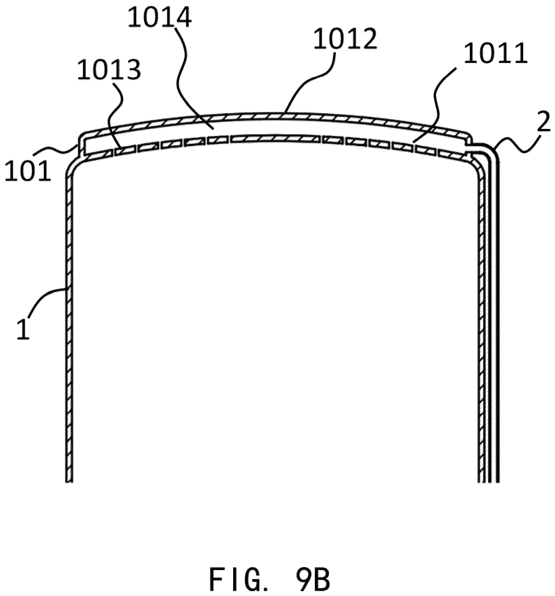

Wherein, as shown in FIG. 9A and FIG. 9B, a top cover 101 is provided at the top of the process tube1, and through holes 1011 is provided on the top cover 101. In the first embodiment, the top cover 101 is a double-layer structure including a top layer 1012 and a bottom layer 1013. And both the top layer 1012 and the bottom layer 1013 of the top cover 101 are arched structure to mitigate the collapse of the top cover 101 at a high temperature of more than 1200°C. A cavity 1014 is formed between the top layer 1012 and the bottom layer 1013 of the top cover 101, and through holes 1011 is provided on the bottom layer 1013 of the top cover 101. The material of the process tube 1 is quartz or silicon carbide (SiC).

As shown in FIG. 2, FIG. 9A and FIG. 9B, the gas supply pipe 2 is arranged along the side wall of the process pipe 1, the first end (lower end) of the gas supply pipe 2 is connected to the external gas tube 4, and the second end (upper end) of the gas supply pipe 2 is connected to the cavity 1014 on the top cover 101. The process gas supplied by the external gas tube 4 is passed into the interior of the process pipe 1 through the gas supply pipe 2 and through holes 1011 on the top cover 101 of the process pipe 1. The liner tube 5 is arranged on the periphery of the process tube 1, and the material of the liner tube 5 is quartz or silicon carbide (SiC). The heating element 6 is sleeved on the periphery of the liner tube 5.

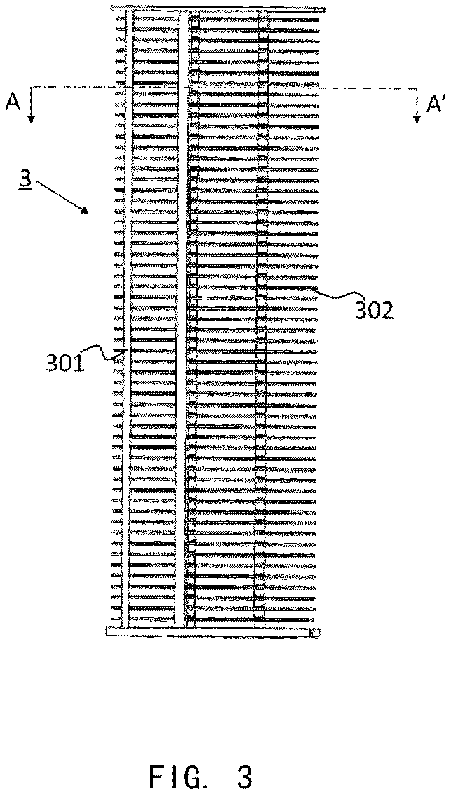

As shown in FIG. 3, a wafer boat 3 is arranged in the process tube 1. To be specific, a wafer boat 3 comprises a supporting frame 301 and supporting plate 302. The supporting plate 302 has multiple layers distributed along the length direction of the supporting frame 301, supporting multiple substrates w. Each substrate w is placed on each layer of the supporting plate 302, and each layer of supporting plate 302 supports the entire bottom of each substrate w, thus reducing the effect of gravity on the surface stress of the substrate w and decreasing the density of lattice dislocation defects in the substrate w.

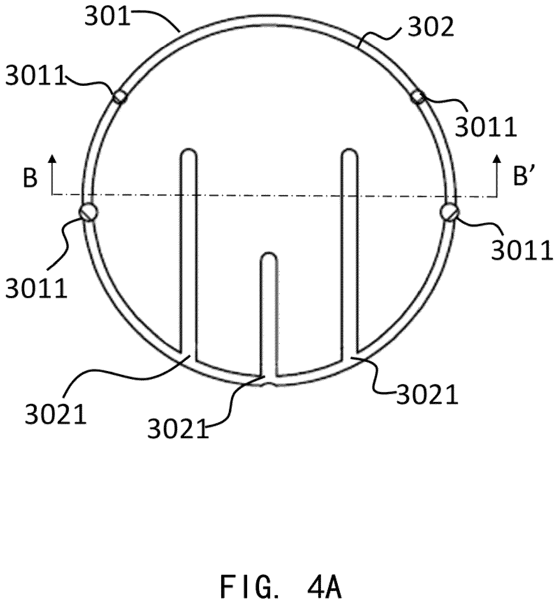

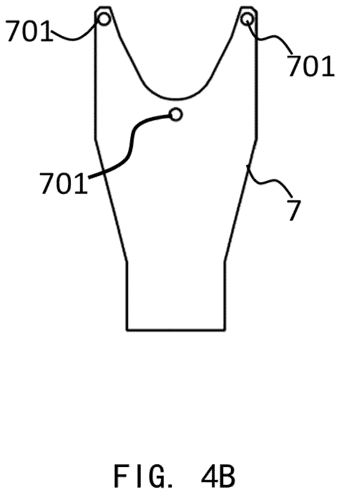

As shown in FIG. 4A, FIG. 4A is a top view of a supporting plate in the AA direction shown in FIG. 3, and FIG. 4B shows a schematic diagram of the manipulator 7 coordinating to the supporting plate 302. In the first embodiment, the manipulator 7 for taking and placing the substrate w sets three suckers 701. Each layer of supporting plate 302 is provided with three guide grooves 3021, and the three guide grooves 3021 correspond to three suckers 701 on the manipulator 7.

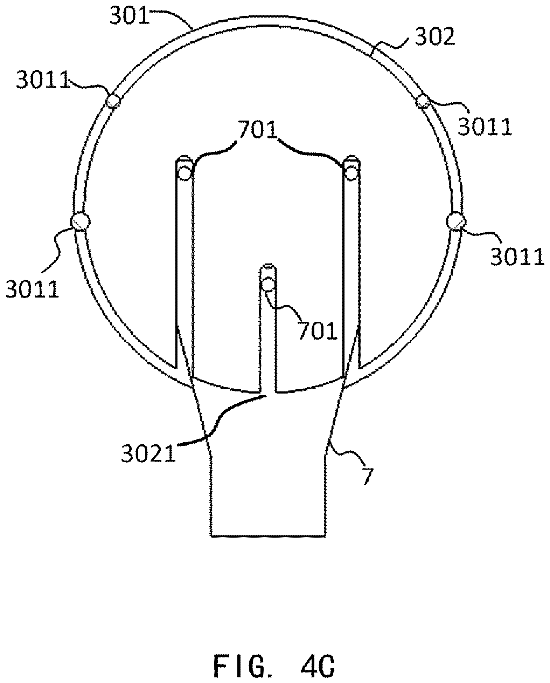

In the present embodiment, the three suckers 701 on the manipulator 7 may be vacuum suckers for sucking the substrate. As shown in FIG. 4C, when the manipulator 7 places the substrate w on or removes the substrate w from each layer of supporting plate 302, the three vacuum suckers 701 provided on the manipulator 7 can firmly suck the substrate w to avoid the substrate w dropping or shifting.

In another embodiment, the three suckers 701 on the manipulator 7 may be solid suckers, and each solid sucker 701 is provided with a sealing ring (not shown in the accompanying drawings). The solid suckers 701 support the substrate w by the friction of the sealing ring, preventing the substrate w from dropping or shifting. Wherein, the solid suckers 701 may be metal suckers, ceramic suckers, carbon fiber suckers, or the like.

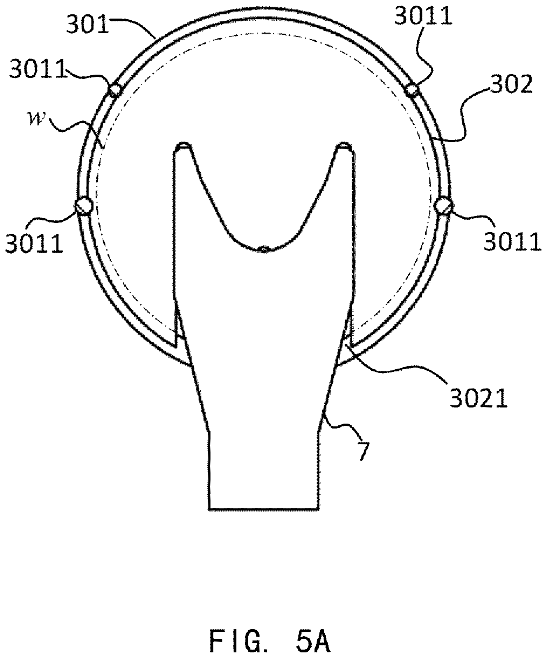

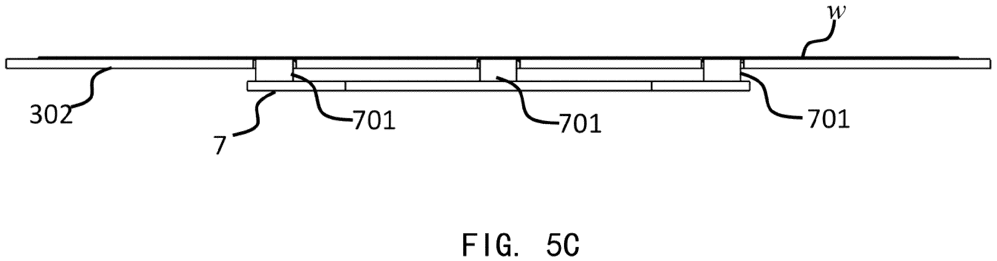

In the present embodiment, as shown in FIGS. 5A to 5C, the three vacuum suckers 701 on the manipulator 7 are inserted into the three guide grooves 3021 and suck the substrate w, removing supporting plate 302 from the substrate w or placing the substrate w on supporting plate 302. The size of the three guide grooves 3021 in the present embodiment is matched with the size of the three vacuum suckers 701, which increases the contact area between the supporting plate 3021 and the substrate w, and effectively downward deformation of the substrate w at a high temperature of over 1200°C, thereby causing defects of lattices in the substrates.

In the present embodiment, the three vacuum suckers 701 on the manipulator 7 are distributed roughly in an isosceles triangle.

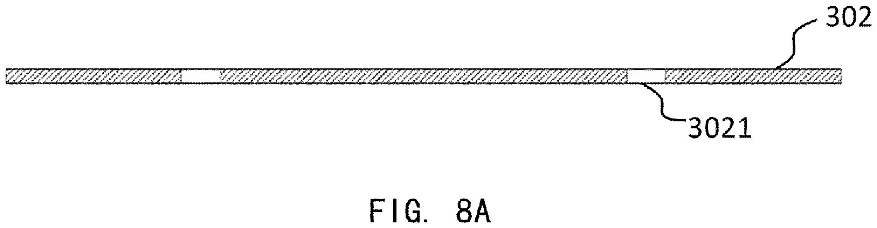

FIG. 8A is a sectional view of supporting plate 302 provided in the first embodiment along the BB' direction shown in FIG. 4A. Each layer of supporting plate 302 is in flat contact with the bottom of the substrate w, which increases the contact area between supporting plate 302 and the substrate w, and ensures that the substrate w is not prone to downward deformation at high temperatures, thus avoiding the defect of lattices in the substrate w.

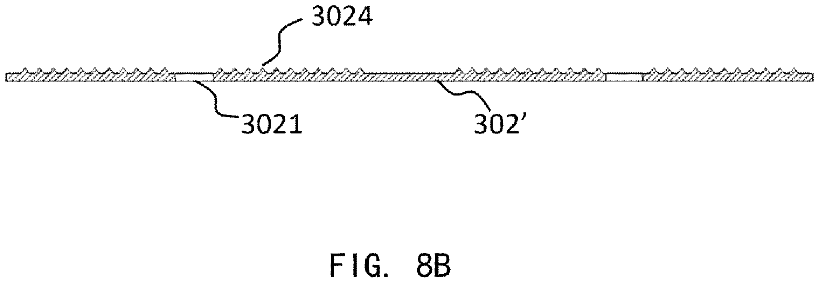

In other embodiments of the present invention, supporting plate 302' provided for another embodiment as shown in FIG. 8B is a cross-sectional view in the direction of BB' shown in FIG. 4A. A plurality of protrusions 3024 are provided on the side of each layer of supporting plate 302" in contact with the bottom of the substrate w, such that a gap is left between supporting plate 302" and the bottom of the substrate w. In this embodiment, the substrate w is in point contact with supporting plate 302", which improves the defect that the substrate w is unevenly heated, compared to the first embodiment in which each layer of supporting plate 302' is in contact with the bottom surface of the substrate w.

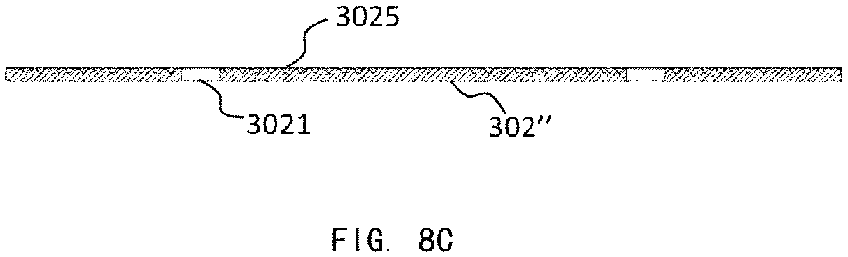

FIG. 8C is a cross-sectional view of the supporting plate 302" provided in another embodiment in the BB' direction shown in FIG. 4A. A plurality of grooves 3025 are provided on the side of each layer of the supporting plate 302" in contact with the bottom of the substrate w, so that a gap is left between supporting plate 302" and the bottom of the substrate w. The substrate w is in point contact with the supporting plate 302", thereby improving the defect that the substrate w is unevenly heated.

In the first embodiment, the multiple layers of supporting plate 302 and the supporting frame 301 are made of different materials. In the process of high-temperature technology, there are differences in the thermal expansion coefficients of different materials, and stress will appear between supporting plate 302 with different thermal expansion coefficients and the supporting frame 301, which will easily cause the supporting frame 301 to be damaged and deformed, and produce impurity particles polluting the substrate w.

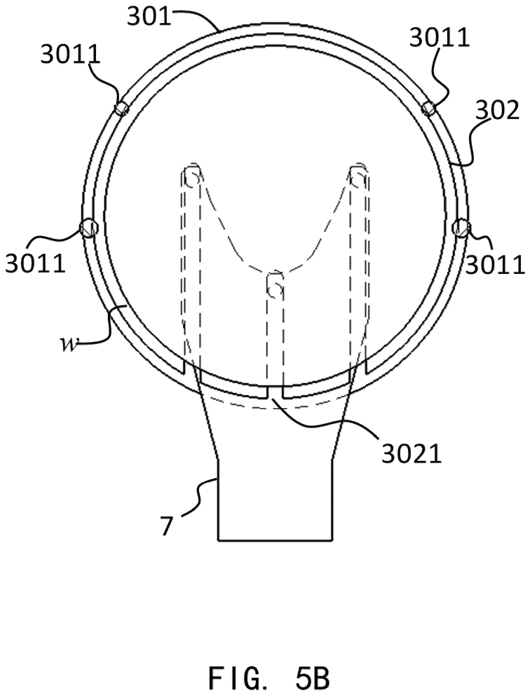

Hence, as shown in FIG. 4A, FIG. 4C, FIG. 5A and FIG. 5B, in order to avoid the generation of stress between supporting plate 302 made of materials with different thermal expansion coefficients and the supporting frame 301, four grooves (not shown in the accompanying drawings) are distributed on the periphery of each layer of supporting plate 302. The supporting frame 301 is provided with four corresponding blocks 3011 at positions corresponding to each layer of supporting plate 302. In the first embodiment, four blocks 3011 are symmetrically distributed on both sides of the circumferential direction of each layer of supporting plate 302, and each layer of supporting plate 302 is clamped on the blocks (3011) of the supporting frame 301 through slots. So that during the high-temperature process, no stress is generated between the supporting plate 302 with different thermal expansion coefficients and the supporting frame 301, thus avoiding the generation of impurity particles to contaminate the substrate w.

In another embodiment, in order to avoid stress between the supporting plate 302 and the supporting frame 301, the supporting plate 302 and the supporting frame 301 may be made of the same material and to be integrally formed, which effectively avoids contamination of the substrate w by impurity particles generated due to deformation of the supporting plate 301 and supporting plate 302 caused by stress.

In the first embodiment, the thickness of supporting plate 302 is 1-3 mm, the material of the supporting plate 302 may be any one of quartz, silicon carbide, diamond, graphite, and graphene. The material of the supporting frame 301 may be any one of quartz, silicon carbide, and silicon. In other embodiments, the substrate w may be made of other materials in addition to silicon.

### Second embodiment

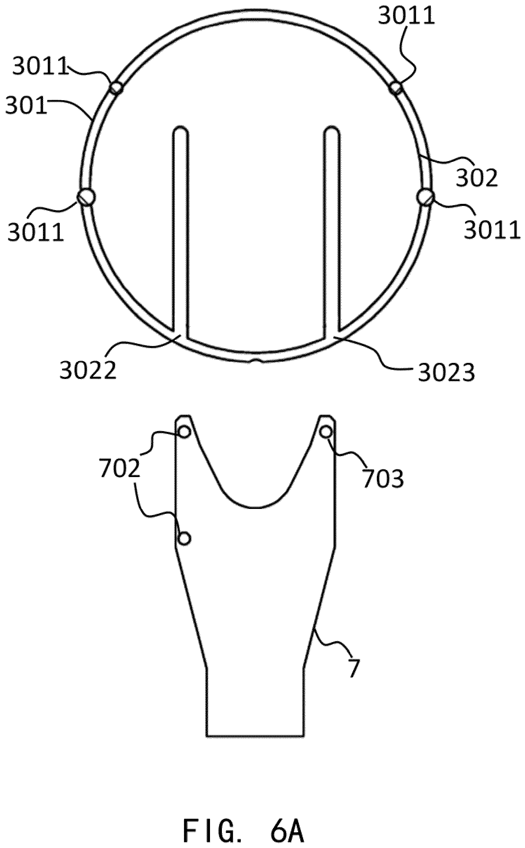

As shown in FIGS. 6A to 6D, the second embodiment provides a high-temperature tube furnace, which differs from the first embodiment in that:

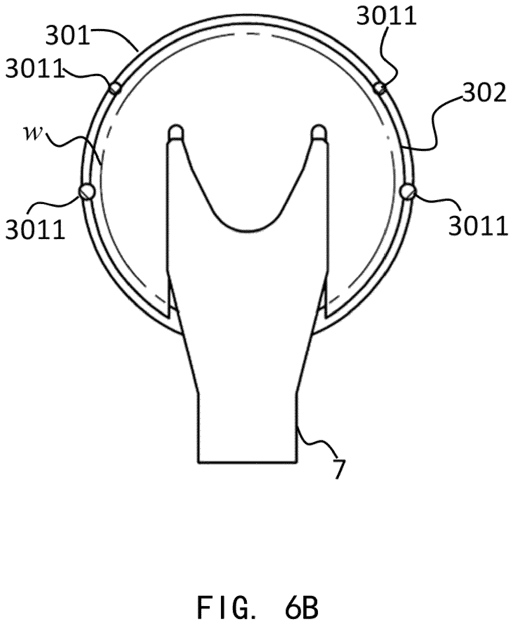

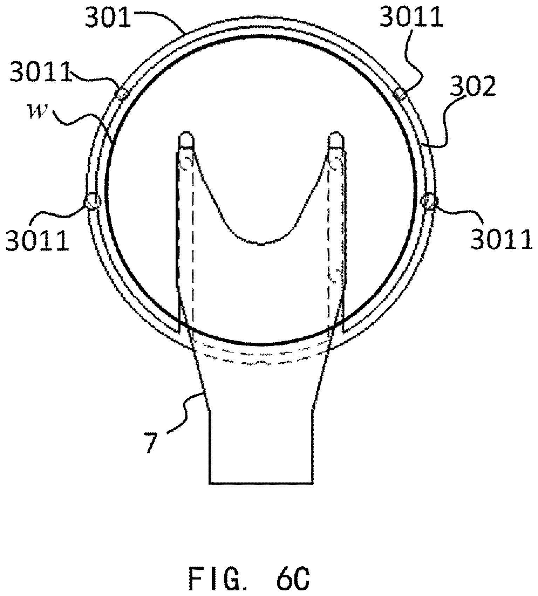

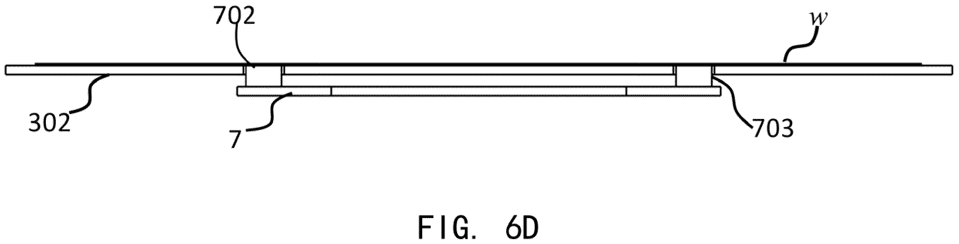

As shown in FIG. 6A, the manipulator 7 for taking and placing the substrate w is provided with three suckers, and two guide grooves are provided on each layer of supporting plate 302 in the second embodiment. The three suckers are all vacuum suckers in the second embodiment. The two vacuum suckers 702 on the manipulator 7 correspond to a guide groove 3022, and the remaining vacuum sucker 703 corresponds to the other guide groove 3023. As shown in FIGS. 6B, 6C and 6D, the three vacuum suckers on the manipulator 7 are inserted into the two guide grooves to remove the substrate w from or place the substrate w on supporting plate 302.

Other settings of the embodiment are identical to those of the first embodiment. It will not be repeated here.

### Third embodiment

The third embodiment provides a high-temperature tube furnace, which differs from the first embodiment in that:

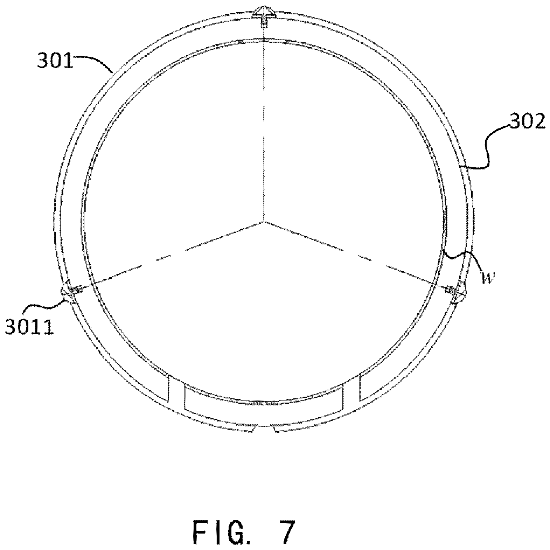

As shown in FIG. 7, in order to avoid stress between supporting plate 302 made of materials with different thermal expansion coefficients and the supporting frame 301, there are three slots on the supporting plate 302 and three blocks 3011 on the supporting frame 301 in the third embodiment. The three blocks 3011 are uniformly distributed on the periphery of each layer of supporting plate 302, so that the angle between each two adjacent blocks 3011 is 120°. Each layer of supporting plate 302 is clamped on the blocks 3011 of the supporting frame 301 through a slot.

Other settings of the embodiment are identical to those of the first embodiment. It will not be repeated here.

### Fourth embodiment

The fourth embodiment provides a high-temperature tube furnace, which differs from the first embodiment in that:

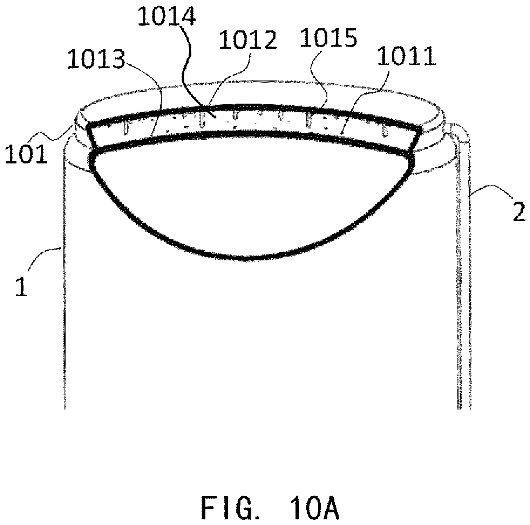

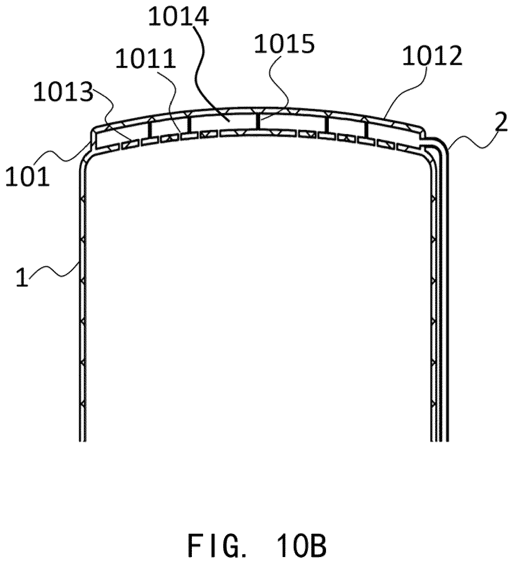

As shown in FIGS. 10A and 10B, in the fourth embodiment, the top layer 1012 and the bottom layer 1013 of the top cover 101 at the top of the process tube 1 are both arched structures, and a stiffener 1015 is provided between the top layer 1012 and the bottom layer 1013 of the top cover 101. The stiffener 1015 connects the top layer 1012 and the bottom layer 1013 of the top cover 101 to reduce the possibility of the top layer 1012 and the bottom layer 1013 of the top cover 101 collapsing due to high temperature, thereby realizing the stability of the process tube 1 at high temperature.

Other settings of the embodiment are identical to those of the first embodiment. It will not be repeated here.

### Fifth embodiment

The fifth embodiment provides a high-temperature tube furnace, which differs from the first embodiment in that:

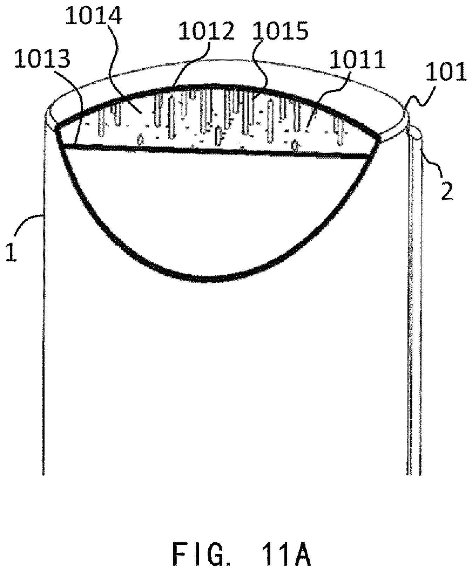

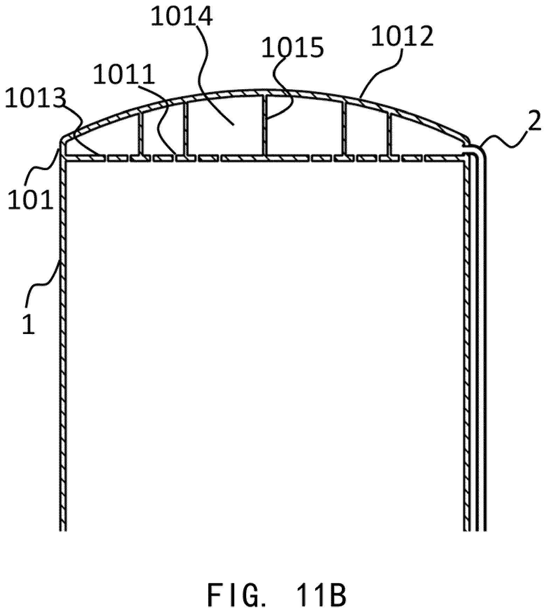

As shown in FIGS. 11A and 11B, the top cover 101 at the top end of the process tube 1 has a double-layer structure including a top layer 1012 and a bottom layer 1013 in the fifth embodiment. The top layer 1012 of the top cover 101 is an arched structure, and the bottom layer 1013 of the top cover 101 is a planar structure. In order to prevent the bottom layer 1013 of the top cover 101 of the planar structure from collapsing at a high temperature of above 1200°C, a stiffener 1015 is provided between the top layer 1012 and the bottom layer 1013 of the top cover 101, which connects the top layer 1012 and the bottom layer 1013 of the top cover 101.

Other settings of the embodiment are identical to those of the first embodiment. It will not be repeated here.

The present invention has disclosed the relevant technology specifically and in detail through the above-described embodiments and related diagrams, so that technicians in the art can implement it accordingly. However, the embodiments described above are intended only to explain the present invention, and not to limit the present invention. The scope of claims of the present invention shall be defined by the claims of the present invention. Any change in the number of components or substitution of equivalent components should still fall within the scope of the claims of the present invention.

## Claims

1. A high-temperature tube furnace, comprising:
a process tube, with a top cover arranged on the top end, the top cover having a plurality of through holes; a gas supply pipe, connecting to the through holes of the top cover of the process tube for introducing process gas into the process tube through the gas supply pipe and the through holes of the top cover of the process tube;
a wafer boat, arranged in the process tube and comprising a supporting frame and supporting plates, wherein the supporting plates are distributed in a plurality of layers along the length direction of the supporting frame to support multiple substrates, and each substrate is placed on each layer of supporting plate and each layer of supporting plate supports the entire bottom of each substrate.

2. The high-temperature tube furnace of claim 1, wherein three guide grooves are provided on each layer of supporting plate, three suckers are provided on a manipulator for taking and placing the substrates, the three guide grooves correspond to the three suckers on the manipulator, the three suckers are inserted in the three guide grooves to take the substrate from the supporting plate or place the substrate on the supporting plate.

3. The high-temperature tube furnace of claim 1, wherein two guide grooves are provided on each layer of supporting plate, three suckers are provided on a manipulator for taking and placing the substrates, two suckers correspond to one guide groove, the remaining one sucker corresponds to the other guide groove, the three suckers are inserted in the two guide grooves to take the substrate from the supporting plate or place the substrate on the supporting plate.

4. The high-temperature tube furnace of claim 2 or 3, wherein the three suckers on the manipulator are vacuum suckers for sucking the substrate.

5. The high-temperature tube furnace of claim 2 or 3, wherein the three suckers on the manipulator are all solid suckers and each of them is provided with a sealing ring, the solid suckers support the substrate through the friction of the sealing ring.

6. The high-temperature tube furnace of claim 1, wherein at least two slots are provided at the periphery of each layer of supporting plate, the supporting frame is provided with at least two blocks at the position corresponding to each layer of supporting plate, at least two blocks correspond to at least two slots one-to-one, and each layer of supporting plate is stuck to the blocks of the supporting frame through the slots.

7. The high-temperature tube furnace of claim 6, wherein the number of the slots is four, the number of the blocks is four, and the four blocks are symmetrically arranged on both sides of the circumferential direction of each layer of supporting plate.

8. The high-temperature tube furnace of claim 6, wherein the number of the slots is three, the three slots are uniformly distributed on the periphery of each supporting plate, and the angle between the two adjacent slots is 120°, the number of the blocks is three, which correspond to the three slots one-to-one.

9. The high-temperature tube furnace of claim 1, wherein the supporting plate and the supporting frame are made of different materials.

10. The high-temperature tube furnace of claim 1, wherein the supporting plate and the supporting frame are made of same material and formed in one.

11. The high-temperature tube furnace of claim 1, wherein the material of the supporting plate is any one of quartz, silicon carbide, diamond, graphite, and graphene.

12. The high-temperature tube furnace of claim 1, wherein the material of the supporting frame is any one of quartz, silicon carbide, and silicon.

13. The high-temperature tube furnace of claim 1, wherein a plurality of protrusions or grooves are provided on the side of the supporting plate in contact with the bottom of the substrate.

14. The high temperature tube furnace of claim 1, wherein the top cover of the process tube is a double-layers structure including a top layer and a bottom layer, the top layer and the bottom layer of the top cover are arched structures.

15. The high temperature tube furnace of claim 14, wherein stiffeners are provided between the top layer and the bottom layer of the top cover to connect the top layer and the bottom layer of the top cover.

16. The high-temperature tube furnace of claim 1, wherein the top cover is a double-layers structure including a top layer and a bottom layer, the top layer of the top cover is an arched structure, and the bottom layer of the top cover is a planar structure, stiffeners are arranged between the top layer and the bottom layer of the top cover to connect the top layer and the bottom layer of the top cover.

17. The high-temperature tube furnace of claim 1, wherein the material of the process tube is quartz or silicon carbide.

18. The high-temperature tub furnace of claim 1, further comprising:
a liner tube, sleeved the periphery of the process pipe; and
heating elements, sleeved the periphery of the liner tube.

19. The high-temperature tube furnace of claim 18, wherein the material of the liner tube is quartz or silicon carbide.
